# EUROPEAN PATENT APPLICATION

(11) **EP 2 107 605 A1**
(43) Date of publication of application: **07.10.2009**
(21) Application number: 09250041.2
(22) Date of filing: 08.01.2009
(51) Int. Cl.: H01L 23/31, H01L 21/768

(54) **Semiconductor device and fabrication method for the semiconductor device**

(30) Priority: 31.03.2008 JP 2008091224; 02.12.2008 JP 2008307289
(71) Applicant: Kabushiki Kaisha Toshiba, Minato-ku Tokyo (JP)
(72) Inventor: Yamamura, Takuji, Tokyo (JP)
(74) Representative: Maury, Richard Philip

(57) **Abstract**

A semiconductor device which could strengthen the mechanical strength of the protective film and with which packaging of the wafer level with electric high reliability is performed and a fabrication method for the semiconductor device are provided. The semiconductor device includes a semiconductor substrate (4A); a field effect transistor (4) including a gate electrode (1), a drain electrode (2), and a source electrode (3) which are formed on the semiconductor substrate (4A) ; a hollow protective film (5) provided on the semiconductor substrate (4A) so that an inner surface bonds to the upper surface of the one or both of the drain electrode (2) and the source electrode (3) of the field effect transistor (4), wherein the hollow protective film (5) includes a first cap layer (7) contacting the upper surface of the one or both of the drain electrode and the source electrode, and a second cap layer (10) placed on the first cap layer (7).

## Description

### BACKGROUND OF THE INVENTION

### 1. Field of the Invention

The present invention relates to a semiconductor device and a fabrication method for the semiconductor device. In particular, the present invention relates to a semiconductor device and a fabrication method for the semiconductor device provided with a package of a wafer level, in a package of a high frequency semiconductor device.

### 2. Description of the Related Art

In a field effect transistor applied to a high frequency semiconductor device, in order to keep airtightness, packaging is achieved by placing a semiconductor device, a matching circuit, etc. in the housing composed of metal, ceramics, etc.

However, the cost concerning the housing of this package was large, and this had become an obstacle of low-pricing in the cost aspect of the semiconductor device. Moreover, in potting by resin etc., the problem that gain reduction occurred by the increase in capacity of an active gate electrode electrically etc. had occurred.

As technology for solving this problem, a wafer level packaging which can keep the airtightness to the semiconductor device itself with a hollow protective film, and can reduce the capacity of a gate electrode is developed and filed as patent application by the present applicant (Japanese Patent Application No. P2008-013721).

However, since the volume of hollow sections was large in order to wrap an active part of the field effect transistor by using this technology, there was a problem that it is anxious about the mechanical strength of the protective film.

On the other hand, in order to reduce the increase in the capacity by a passivation film, a semiconductor device and a fabrication method for the semiconductor device. which provides a hollow area between the passivation film and a metal electrode which a high frequency signal outputs and inputs, are already disclosed (for example, refer to Patent Document 1).

On the other hand, a semiconductor device and a fabrication method for the semiconductor device which reduces the parasitic capacitance between a source electrode or a drain electrode, and a gate electrode, and improves high frequency characteristics by removing an insulating film under the eaves of the gate electrode toward a mold are already disclosed (for example, refer to Patent Document 2).

### Patent Document 1:

Japanese Patent Application Laying-Open Publication No. H06-140440

### Patent Document 2:

Japanese Patent Application Laying-Open Publication No. H11-354540

### SUMMARY OF THE INVENTION

According to an aspect of the invention, a semiconductor device comprises a semiconductor substrate; a field effect transistor comprising a gate electrode, a drain electrode, and a source electrode which are formed on the semiconductor substrate; and a hollow protective film provided on the semiconductor substrate so that an inner surface bonds to an upper surface of the drain electrode and the source electrode of the field effect transistor.

According to another aspect of the invention, a semiconductor device comprises a semiconductor substrate; a field effect transistor comprising a gate electrode, a drain electrode, and a source electrode which are formed on the semiconductor substrate; and a hollow protective film provided on the semiconductor substrate so that an inner surface bonds to an upper surface of the source electrode of the field effect transistor.

According to another aspect of the invention, a semiconductor device comprises a semiconductor substrate; a field effect transistor comprising a gate electrode, a drain electrode, and a source electrode which are formed on the semiconductor substrate; and a hollow protective film provided on the semiconductor substrate so that an inner surface bonds to an upper surface of the drain electrode of the field effect transistor.

According to another aspect of the invention, a fabrication method for a semiconductor device comprises forming a gate electrode, a drain electrode, and a source electrode on a semiconductor substrate, and forming a field effect transistor; and forming a hollow protective film on the semiconductor substrate so that an inner surface bonds to an upper surface of one or both of the drain electrode and the source electrode of the field effect transistor.

According to the present invention, a semiconductor device and a fabrication method for the semiconductor device which could strengthen the mechanical strength of the protective film and with which packaging of the wafer level with electric high reliability is performed can be provided.

### BRIEF DESCRIPTION OF DRAWINGS

Fig. 1 is a schematic plane pattern configuration diagram showing a semiconductor device according to a first embodiment of the present invention.
Fig. 2 is a schematic cross-sectional configuration chart explaining one process of a fabrication method of the semiconductor device according to the first embodiment of the present invention.
Fig. 3 is a schematic cross-sectional configuration chart explaining one process of the fabrication method of the semiconductor device according to the first embodiment of the present invention.
Fig. 4 is a detailed schematic plane pattern configuration diagram showing the semiconductor device according to the first embodiment of the present invention.
Fig. 5 is a detailed schematic plane pattern configuration diagram showing a semiconductor device according to a modified example 1 of the first embodiment of the present invention.
Fig. 6 is a detailed schematic plane pattern configuration diagram showing a semiconductor device according to a modified example 2 of the first embodiment of the present invention.
Fig. 7 is a schematic cross section configuration diagram showing a semiconductor device according to a modified example 3 of the first embodiment of the present invention.
Fig. 8 is a schematic cross section configuration diagram showing a semiconductor device according to a second embodiment of the present invention.
Fig. 9 is a schematic cross section configuration diagram showing a semiconductor device according to a modified example 1 of the second embodiment of the present invention.
Fig. 10 is a schematic cross section configuration diagram showing a semiconductor device according to a modified example 2 of the second embodiment of the present invention.
Fig. 11 is a schematic cross section configuration diagram showing a semiconductor device according to a modified example 3 of the second embodiment of the present invention.
Fig. 12 is a schematic cross section configuration diagram of a semiconductor device according to a third embodiment of the present invention.

### DETAILED DESCRIPTION OF THE EMBODIMENTS

Various embodiments of the present invention will be described with reference to the accompanying drawings. It is to be noted that the same or similar reference numerals are applied to the same or similar parts and elements throughout the drawings, and the description of the same or similar parts and elements will be omitted or simplified. Generally, and as is in the representation of the cross-sectional diagram, it will be appreciated that the various drawings are not drawn to scale from one figure to another nor inside a given figure, and in particular that the circuit diagrams are arbitrarily drawn for facilitating the reading of the drawings. In the following descriptions, numerous specific details are set forth such as specific material layers, etc. to provide a thorough understanding of the present invention. However, it will be obvious to those skilled in the art that the present invention may be practiced without such specific details. In other instances, the material layers well- known have been shown in the cross-sectional diagrams form in order to not obscure the present invention with unnecessary detail. Drawings are schematic, not actual, and may be inconsistent in between in scale, ratio, etc.

The embodiments shown below exemplify a semiconductor device that are used to implement the technical ideas according to the present invention, and do not limit the technical ideas according to the present invention to those that appear below. These technical ideas, according to the present invention, may receive a variety of modifications that fall within the claims.

The embodiment shown in the following exemplifies the device and method for materializing the technical idea of this invention, and this embodiment of the invention does not specify assignment of each component parts, etc. as the following. This embodiment of the invention can add various change in scope of claims.

### [FIRST EMBODIMENT]

### (DEVICE STRUCTURE)

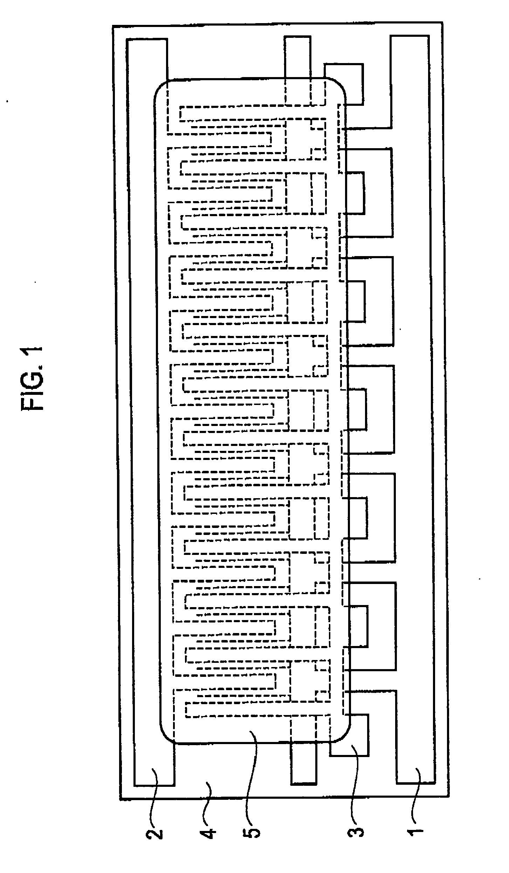

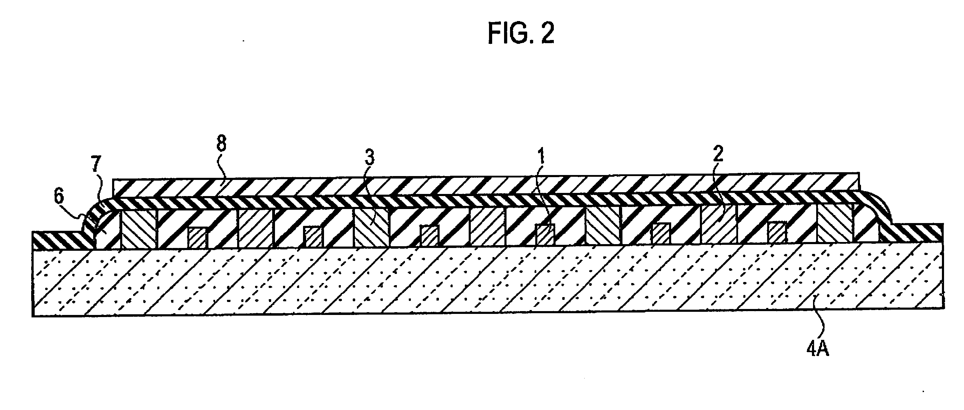

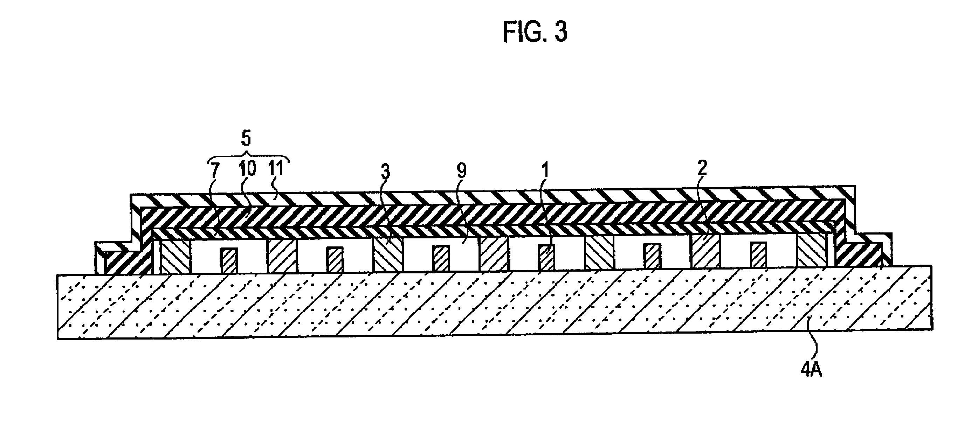

A schematic plane pattern configuration of a semiconductor device according to a first embodiment of the present invention is expressed as shown in Fig. 1. A schematic section structure explaining one process of a fabrication method of the semiconductor device according to the first embodiment is expressed as shown in Fig. 2 and Fig. 3.

The semiconductor device according to the first embodiment includes a semiconductor substrate 4A, a field effect transistor 4, and a hollow protective film 5, as shown in Fig. 1 to Fig. 3. The field effect transistor 4 includes a gate electrode 1, a drain electrode 2, and a source electrode 3 which are formed on the semiconductor substrate. The hollow protective film 5 is provided on the semiconductor substrate 4A so that an inner surface may bond to an upper surface of the drain electrode 2 and the source electrode 3 of the field effect transistor 4.

The hollow protective film 5 includes a first cap layer 7 contacting the drain electrode 2 and the source electrode 3, and a second cap layer 10 placed on the first cap layer 7.

The hollow protective film 5 further includes a third cap layer 11 placed on the second cap layer 10.

The first cap layer 7 and the second cap layer 10 can be composed by an insulating film, for example, can be composed by a silicon dioxide film (SiO₂ film).

The third cap layer 11 can be composed by an insulating film, for example, can be composed by a silicon nitride film (SiN film).

As shown in Fig. 1 and Fig. 3, the field effect transistor 4 includes the hollow protective film 5, and the field effect transistor 4 including the gate electrode 1, the drain electrode 2, and the source electrode 3 is formed on the semiconductor substrate 4A. The hollow protective film 5 is provided on the semiconductor substrate 4A so that the polar zone composed of the gate electrode 1, the drain electrode 2, and the source electrode 3 of this field effect transistor 4 may be covered. Here, the hollow protective film 5 is provided so that the inner surface may bond to the upper surface of the drain electrode 2 and the source electrode 3.

### (Fabrication Method)

The fabrication method of the semiconductor device according to the first embodiment includes: the step of forming the gate electrode 1, the drain electrode 2, and the source electrode 3 on the semiconductor substrate 4A, thereby forming the field effect transistor 4; and the step of forming the hollow protective film 5 on the semiconductor substrate 4A so that the inner surface may bond to the upper surface of one or both of the drain electrode 2, and the source electrode 3 of the field effect transistor 4, as shown in Fig. 1 to Fig. 3.

Moreover, the step of forming the hollow protective film 5 includes: the step of forming the sacrifice layer 6 on the gate electrode 1 and the semiconductor substrate 4A except for the drain electrode 2 and the source electrode 3; the step of forming the first cap layer 7 contacting the upper surface of one or both of the drain electrode 2 and the source electrode 3; the step of forming an opening 12 in the edge of the first cap layer 7; the step of sending oxygen plasma through the opening 12, and gasifying and removing the sacrifice layer 6 by an oxygen plasma asher, and forming the hollow unit 9; and the step of forming the second cap layer 10 on the first cap layer 7, and sealing the opening 12.

The step of forming the hollow protective film 5 may further include the step of forming the third cap layer 11 on the second cap layer 10.

Next, the fabrication method of the semiconductor device according to the first embodiment will be explained using Fig. 1 to Fig. 3.
(a) First of all, form the field effect transistor 4 composed of the gate electrode 1, the drain electrode 2, the source electrode 3, etc. on the semiconductor substrate 4A.
(b) Next, form the sacrifice layer 6 composed of, for example, photosensitive polyimide on the part except for the drain electrode 2 and the source electrode 3, i.e., the active part of the gate electrode 1, and the semiconductor substrate 4A. That is, after applying the sacrifice layer 6 completely on the semiconductor substrate 4A, it patterns toward this sacrifice layer 6 so that the active part of the gate electrode 1 except for the drain electrode 2 and the source electrode 3 maybe covered. In addition, not only the photosensitive polyimide but other photosensitive heat-resistant materials may be sufficient as the sacrifice layer 6. Moreover, if heat treatment is not used for future steps, photosensitive materials, such as photoresist, may be sufficient as the sacrifice layer 6.
(c) Next, form the first cap layer 7 composed of an insulating film so that the sacrifice layer 6 may be covered on the upper part of the sacrifice layer 6. This first cap layer 7 can be formed, for example by depositing a silicon dioxide film by CVD (Chemical Vapor Deposition).
(d) Next, as shown in Fig. 2, further form the photoresist layer 8 composed of photosensitive materials on the upper part of the first cap layer 7.
(e) Next, as shown in Fig. 2, perform a patterning process so that the edge of the first cap layer 7 may be exposed by the photoresist layer 8. Via this photoresist layer 8, the first cap layer 7 is etched by RIE (Reactive Ion Etching) method, and the edge of the first cap layer 7 is exposed.
(f) Next, form the opening (extracting hole), not illustrated, on the edge of the first cap layer 7 after removing the photoresist layer 8.
(g) Next, send the oxygen plasma through the opening, and gasify and remove the sacrifice layer 6 by an oxygen plasma asher, thereby form the hollow part (cavity part) 9. Although Fig. 3 is a sectional view of the field effect transistor showing the state where this sacrifice layer 6 is removed and the hollow part 9 is formed, the sacrifice layer 6 is removed from the active part of the gate electrode 1, and the hollow part 9 is formed, as shown in the same figure.
(h) Next, as the second cap layer 10, deposit, for example, a silicon dioxide film as the insulating film by a spattering process, and secure the airtightness of the hollow part 9. (1) Next, as shown in Fig. 3, deposit a nitride film as the third cap layer 11 by using, for example, plasma CVD, on the second cap layer 10. By the third cap layer 11, the airtightness and moisture resistance are securable.

Thus, the hollow protective film 5 which laminates the first cap layer 7, second cap layer 10, and third cap layer 11 is formed. The first cap layer 7 that is an innermost (lowest) layer of this hollow protective film 5 contacts the upper surface of the drain electrode 2 and the source electrode 3. For this reason, since the drain electrode 2 and the source electrode 3 may support the hollow protective film 5 from that inner side, the mechanical intensity of the hollow protective film 5 is reinforced.

In addition, other insulating films which are excellent in the airtightness and the moisture resistance may be sufficient as the third cap layer 11. Moreover, if the second cap layer 10 is provided with sufficient airtightness and moisture resistance, there may not be the third cap layer 11.

Since the hollow protective film 5 formed in this way has composition which the electrodes except active gate electrode 1 electrically, i.e., the drain electrode 2, and the source electrodes 3, supports as a support unit, the mechanical strength of the hollow protective film 5 does not become weaker even if the volume of the hollow sections becomes large, and the bad influence of electrical characteristics is also eliminated.

### (Opening)

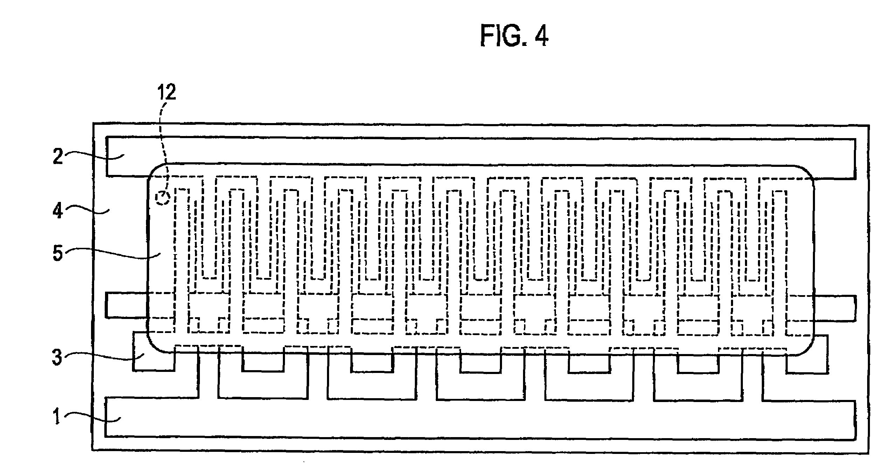

A detailed schematic plane pattern configuration of the semiconductor device according to the first embodiment is expressed as shown in Fig. 4. As clearly from Fig. 4, the opening 12, which is not shown in Fig. 2 to Fig. 3, is shown in the periphery of the hollow protective film 5. Since this opening 12 is formed toward the first cap layer 7 on the fabricating process and is sealed by the subsequent fabricating process of the second cap layer 10, this opening 12 is shown by the dotted line.

### (MODIFIED EXAMPLE 1)

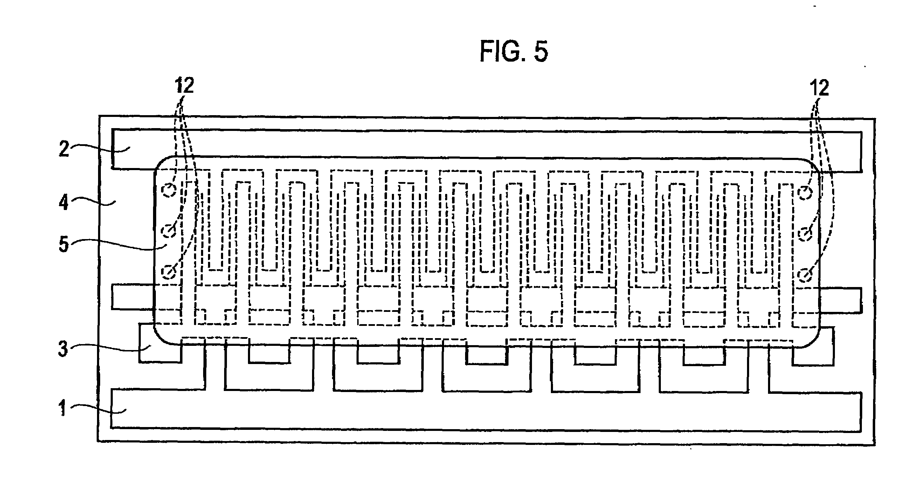

As shown in Fig. 5, a detailed schematic plane pattern configuration of a semiconductor device according to a modified example 1 of the first embodiment is an example by which a plurality of openings 12 are placed at the periphery of the hollow protective film 5, and other configurations are the same as that of the first embodiment. By placing a plurality of openings 12 at the periphery of the hollow protective film 5, oxygen plasma is sendable through the opening 12, the sacrifice layer 6 can be gasified and removed by an oxygen plasma asher, and the processing time of the step of forming the hollow part 9 can be shortened.

### (MODIFIED EXAMPLE 2)

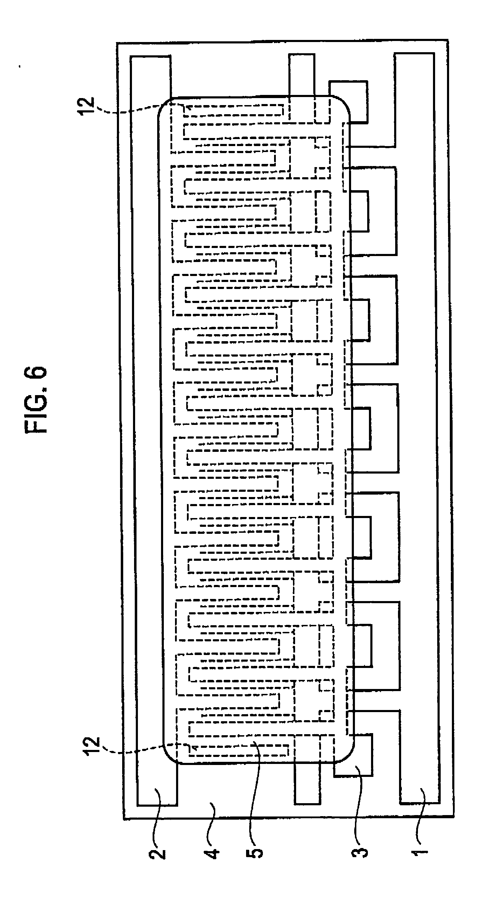

As shown in Fig. 6, a detailed schematic plane pattern configuration of a semiconductor device according to a modified example 2 of the first embodiment is an example by which the openings 12 are placed at rectangle stripe shape at the periphery of the hollow protective film 5, and other configurations are the same as that of the first embodiment. By placing the openings 12 to rectangle stripe shape at the periphery of the hollow protective film 5, oxygen plasma is sendable through the openings 12, the sacrifice layer 6 can be gasified and removed by an oxygen plasma asher, and the processing time of the step of forming the hollow part 9 can be further shortened.

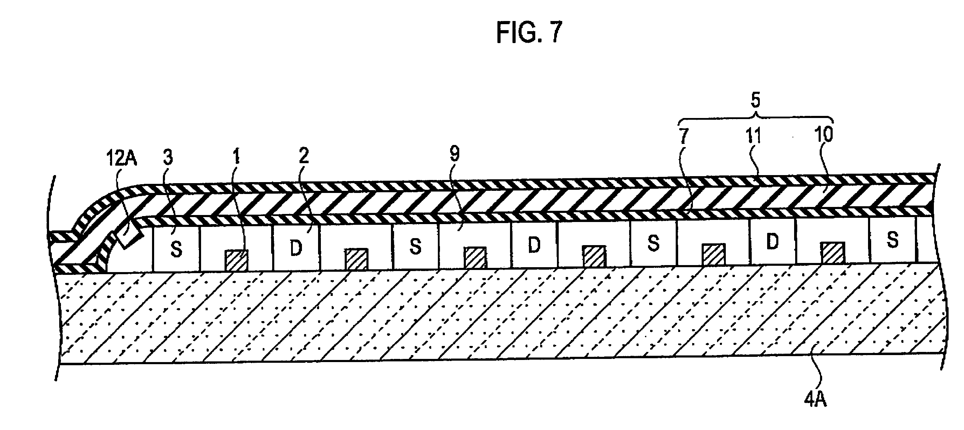

The schematic section structure of the semiconductor device according to the modified examples 2 to 3 of the first embodiment includes a semiconductor substrate 4A, a field effect transistor 4, and a hollow protective film 5, as shown in Fig. 7. The field effect transistor 4 has a gate electrode 1, a drain electrode 2, and a source electrode 3 which are formed on the semiconductor substrate 4A. The hollow protective film 5 is provided on the semiconductor substrate 4A so that an inner surface may bond to the upper surface of the drain electrode 2 and the source electrode 3 of the field effect transistor 4.

The hollow protective film 5 includes a first cap layer 7 contacting the drain electrode 2 and the source electrode 3, and a second cap layer 10 placed on the first cap layer 7.

The hollow protective film 5 further includes a third cap layer 11 placed on the second cap layer 10.

The opening 12 is formed in the first cap layer 7 in the periphery of the hollow protective film 5, the sacrifice layer 6 is gasified and removed by an oxygen plasma asher through this opening 12, and the opening 12 is sealed by the second cap layer 10 in the sealed part 12A after forming the hollow part 9.

Since the hollow protective film 5 is supported by the drain electrode 2 and the source electrode 3 as a support unit according to the first embodiment, even if the volume of hollow sections becomes large, the mechanical strength of the hollow protective film 5 does not become weaker. Moreover, reliable semiconductor device can be obtained without receiving the electrical influence from others in the process in which the hollow protective film 5 is formed, since the electrodes 2 except active gate electrode 1 electrically, i.e., the drain electrode, and the source electrodes 3 are applied as the support unit.

### [SECOND EMBODIMENT]

### (DEVICE STRUCTURE)

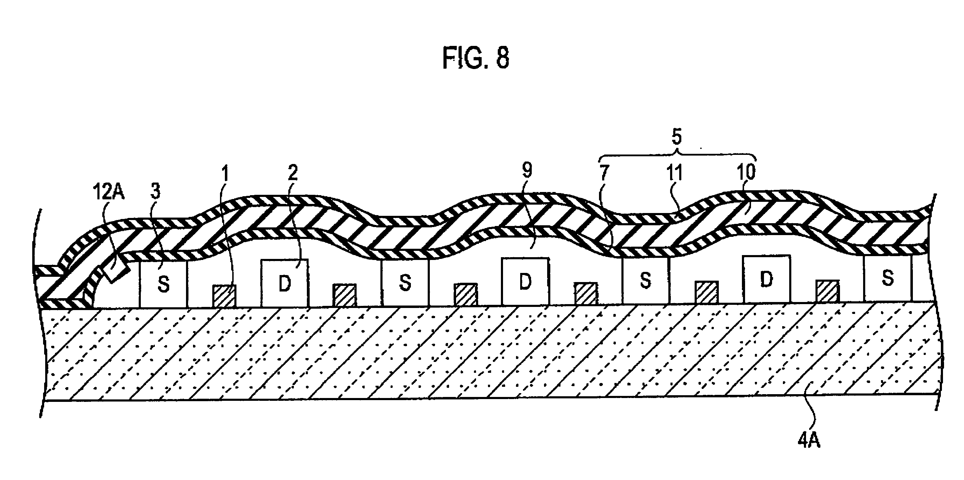

A schematic plane pattern configuration of a semiconductor device according to a second embodiment of the present invention is similarly expressed as Fig. 1 or Fig. 4 to Fig. 6. A schematic section structure of the semiconductor device according to the second embodiment is expressed as shown in Fig. 8.

The semiconductor device according to the second embodiment includes a semiconductor substrate 4A, a field effect transistor 4, and a hollow protective film 5, as shown in Fig. 4 to Fig. 6, and Fig. 8. The field effect transistor 4 has a gate electrode 1, a drain electrode 2, and a source electrode 3 which are formed on the semiconductor substrate 4A. The hollow protective film 5 is provided on the semiconductor substrate 4A so that an inner surface may bond to the upper surface of the source electrode 3 of the field effect transistor 4.

The hollow protective film 5 includes a first cap layer 7 contacting the source electrode 3, and a second cap layer 10 placed on the first cap layer 7.

The hollow protective film 5 further includes a third cap layer 11 paced on the second cap layer 10.

The first cap layer 7 and the second cap layer 10 can compose an insulating film, for example, can be composed by a silicon dioxide film.

The third cap layer 11 can compose an insulating film, for example, can be composed by a silicon nitride film.

The opening 12 is formed in the first cap layer 7 in the periphery of the hollow protective film 5, the sacrifice layer 6 is gasified and removed by an oxygen plasma asher through this opening 12, and the opening 12 is sealed by the second cap layer 10 in the sealed part 12A after forming the hollow part 9.

Since the hollow protective film 5 is supported by the source electrode 3 as a support unit according to the second embodiment, even if the volume of hollow sections becomes large, the mechanical strength of the hollow protective film 5 does not become weaker. Moreover, a reliable semiconductor device can be obtained without receiving the electrical influence from others in the process in which the hollow protective film 5 is formed, since the electrodes 2 except active gate electrode 1 electrically, i.e., the source electrodes 3 is applied as the support unit.

### (MODIFIED EXAMPLE 1)

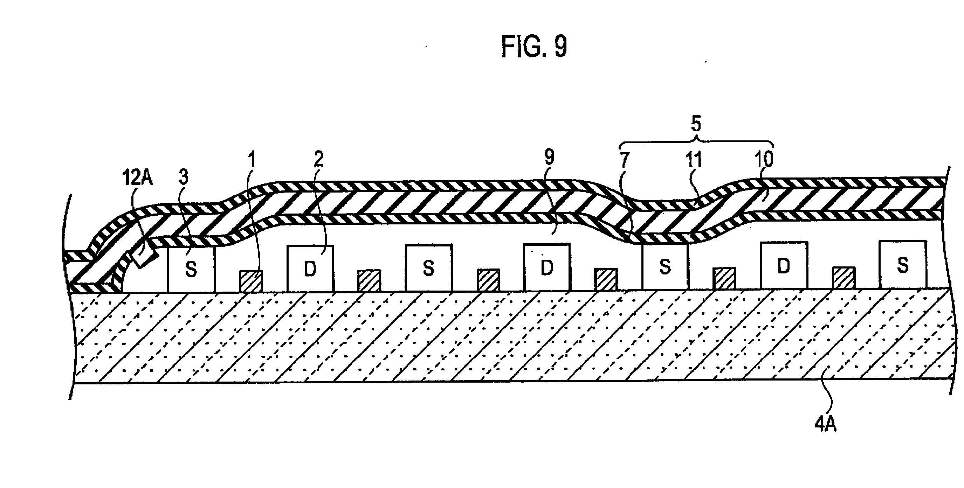

A detailed schematic section structure of a semiconductor device according to amodified example 1 of the second embodiment is not a configuration whose the first cap layer 7 contacts all the source electrodes 3 but a configuration placed so that the source electrode 3 placed at stripe shape may be contacted by every other one for example, as shown in Fig. 9.

The opening 12 is formed in the first cap layer 7 in the periphery of the hollow protective film 5, the sacrifice layer 6 is gasified and removed by an oxygen plasma asher through this opening 12, and the opening 12 is sealed by the second cap layer 10 in the sealed part 12A after forming the hollow part 9.

The first cap layer 7 may be placed so that the source electrode 3 placed at stripe shape may be contacted by every two for example. Or the first cap layer 7 may be provided with the configuration which contacts the source electrode 3 at random.

Since the hollow protective film 5 is supported by the source electrode 3 as a support unit according to the modified example 1 of the second embodiment, even if the volume of hollow sections becomes large, the mechanical strength of the hollow protective film 5 does not become weaker. Moreover, a reliable semiconductor device can be obtained without receiving the electrical Influence from others in the process in which the hollow protective film 5 is formed, since the electrodes 2 except active gate electrode 1 electrically, i.e., the source electrodes 3 are applied as the support unit.

### (MODIFIED EXAMPLE 2)

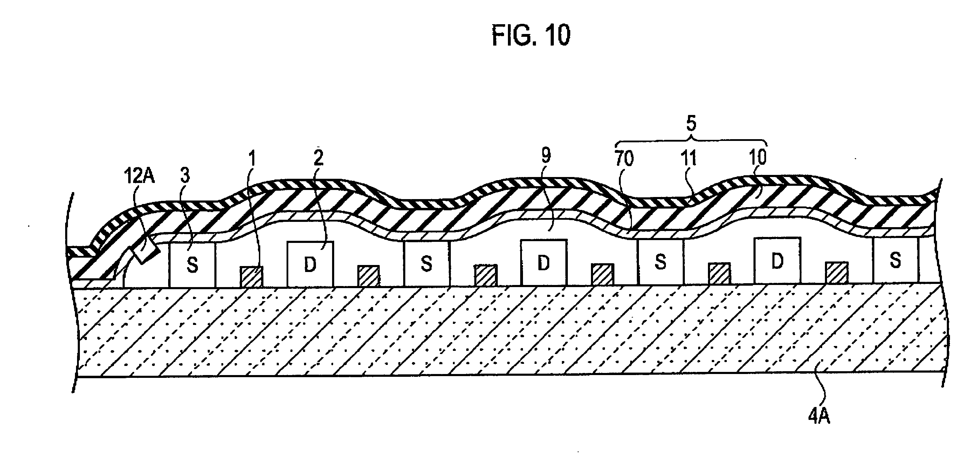

A detailed schematic section structure of a semiconductor device according to a modified example 2 of the second embodiment has the characteristic at the point that the first cap layer 70 is composed of a metal layer, as shown in Fig. 10.

Aluminum can compose the first cap layer 70, for example.

As shown in Fig. 10, the opening 70 is formed in the first cap layer 7 in the periphery of the hollow protective film 5, the sacrifice layer 6 is gasified and removed by an oxygen plasma asher through this opening 12, and the opening 12 is sealed by the second cap layer 10 in the sealed part 12A after forming the hollow part 9.

According to the modified example 2 of the second embodiment, since the first cap layer 70 formed by a metal layer is connected to the source electrode 3, a shielding effect is obtained and a stable semiconductor device is provided electrically by applying potential of the first cap layer 70 into earth potentials.

Moreover, since the hollow protective film 5 is supported by the source electrode 3 as a support unit according to the modified example 2 of the second embodiment, even if the volume of hollow sections becomes large, the mechanical strength of the hollow protective film 5 does not become weaker. Moreover, a reliable semiconductor device can be obtained without receiving the electrical influence from others in the process in which the hollow protective film 5 is formed, since the electrodes 2 except active gate electrode 1 electrically, i.e., the source electrodes 3 are applied as the support unit.

### (MODIFIED EXAMPLE 3)

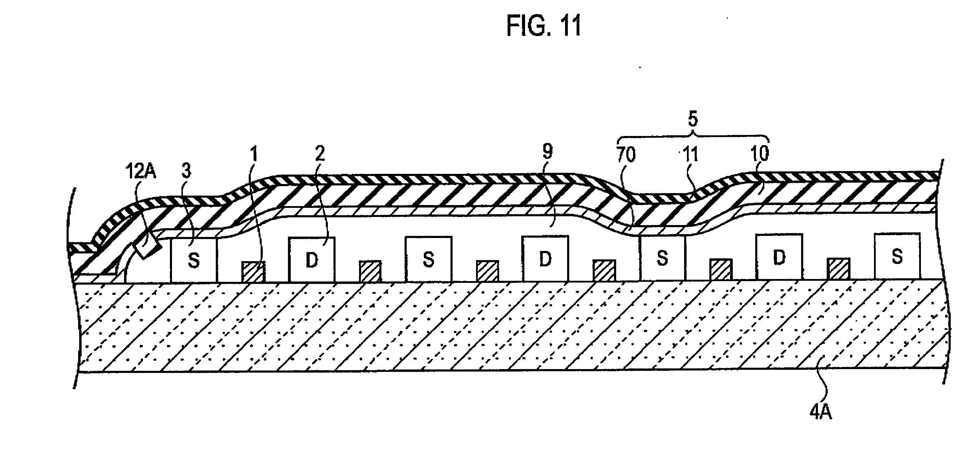

As shown in Fig. 11, a detailed schematic section structure of a semiconductor device according to a modified example 3 of the second embodiment has the characteristic in the point that the first cap layer 70 is composed of a metal layer, and the source electrode 3 placed at stripe shape may be contacted every other one for example, instead of the configuration which contacts all the source electrodes 3.

As shown in Fig. 10, the opening 70 is formed in the first cap layer 7 in the periphery of the hollow protective film 5, the sacrifice layer 6 is gasified and removed by an oxygen plasma asher through this opening 12, and the opening 12 is sealed by the second cap layer 10 in the sealed part 12A after forming the hollow part 9.

The first cap layer 70 may be placed so that the source electrode 3 placed at stripe shape may be contacted by every two for example. Or the first cap layer 70 may be provided with the configuration which contacts the source electrode 3 at random.

According to the modified example 3 of the second embodiment, since the first cap layer 70 formed by a metal layer is connected to the source electrode 3, a shielding effect is obtained and a stable semiconductor device is provided electrically by applying potential of the first cap layer 70 into earth potentials.

Moreover, since the hollow protective film 5 is supported by the source electrode 3 as a support unit according to the modified example 3 of the second embodiment, even if the volume of hollow sections becomes large, the mechanical strength of the hollow protective film 5 does not become weaker. Moreover, a reliable semiconductor device can be obtained without receiving the electrical influence from others in the process in which the hollow protective film 5 is formed, since the electrodes 2 except active gate electrode 1 electrically, i.e., the source electrodes 3 is applied as the support unit.

### [THIRD EMBODIMENT]

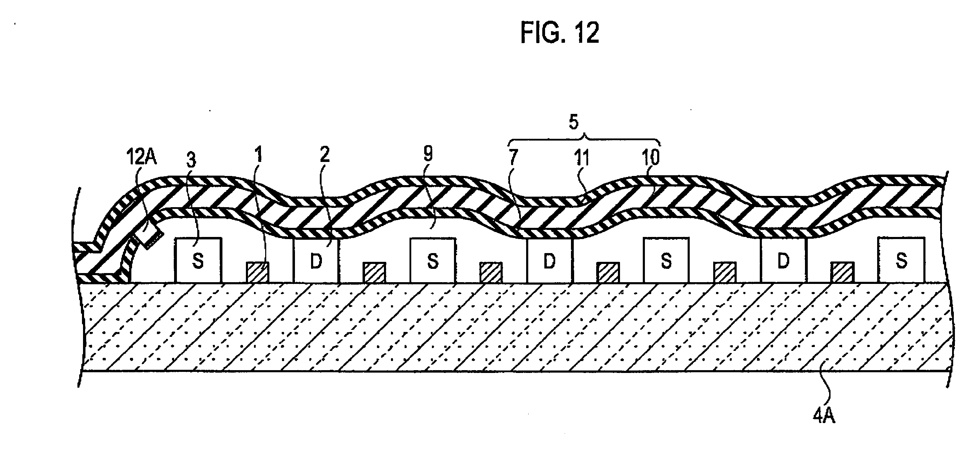

A schematic plane pattern configuration of a semiconductor device according to a third embodiment of the present invention is similarly expressed as Fig. 1 or Fig. 4 to Fig. 6. A schematic section structure of the semiconductor device according to the third embodiment is expressed as shown in Fig. 12.

The semiconductor device according to the third embodiment includes a semiconductor substrate 4A, a field effect transistor 4, and a hollow protective film 5, as shown in Fig. 4 to Fig. 6, and Fig. 12. The field effect transistor 4 has a gate electrode 1, a drain electrode 2, and a source electrode 3 which are formed on the semiconductor substrate 4A. The hollow protective film 5 is provided on the semiconductor substrate 4A so that an inner surface may bond to the upper surface of the drain electrode 2 of the field effect transistor 4.

The hollow protective film 5 includes a first cap layer 7 contacting the drain electrode 2, and a second cap layer 10 placed on the first cap layer 7.

The hollow protective film 5 further includes a third cap layer 11 placed on the second cap layer 10.

The first cap layer 7 and the second cap layer 10 can compose an insulating film, for example, can be composed by a silicon dioxide film.

The third cap layer 11 can compose an insulating film, for example, can be composed by a silicon nitride film.

The opening 12 is formed in the first cap layer 7 in the periphery of the hollow protective film 5, the sacrifice layer 6 is gasified and removed by an oxygen plasma asher through this opening 12, and the opening 12 is sealed by the second cap layer 10 in the sealed part 12A after forming the hollow part 9.

The first cap layer 7 may be placed so that the drain electrode 2 placed at stripe shape may be contacted by every two for example. Or the first cap layer 7 may be provided with the configuration which contacts the drain electrode 2 at random.

Since the hollow protective film 5 is supported by the drain electrode 2 as a support unit according to the third embodiment, even if the volume of hollow sections becomes large, the mechanical strength of the hollow protective film 5 does not become weaker. Moreover, a reliable semiconductor device can be obtained without receiving the electrical influence from others in the process in which the hollow protective film 5 is formed, since the electrodes 2 except active gate electrode 1 electrically, i.e., the drain electrode is applied as the support unit.

### [OTHER EMBODIMENS]

While the present invention is described in accordance with the aforementioned first through third embodiments, it should not be understood that the description and drawings that configure part of this disclosure are to limit the present invention. This disclosure makes clear a variety of alternative embodiments, working examples, and operational techniques for those skilled in the art.

Such being the case, the present invention covers a variety of embodiments, whether described or not.

### INDUSTRIAL APPLICABILITY

According to the present invention, a semiconductor device has a wide range of application fields, such as an internally matched power amplifier, a power MMIC (Monolithic Microwave Integrated Circuit), a microwave power amplifier, a millimeter-wave power amplifier, and a high frequency MEMS (Micro Electro Mechanical Systems) device.

## Claims

1. A semiconductor device comprising:
a semiconductor substrate (4A);
a field effect transitor (4) which comprises a gate electrode (1), a drain electrode (2), and a source electrode (3) which are formed on the semiconductor substrate; and
a hollow protective film (5) provided on the semiconductor substrate so that an inner surface bonds to an upper surface of the drain electrode and the source electrode of the field effect transistor.

2. The semiconductor device according to claim 1, wherein the hollow protective film comprises a first cap layer (7) contacting the drain electrode and the source electrode, and a second cap layer (10) placed on the first cap layer.

3. A semiconductor device comprising:
a semiconductor substrate;
a field effect transistor (4) comprising a gate electrode (1), a drain electrode (2), and a source electrode (3) which are formed on the semiconductor substrate; and
a hollow protective film (5) provided on the semiconductor substrate so that an inner surface bonds to an upper surface of the source electrode of the field effect transistor.

4. The semiconductor device according to claim 3, wherein the hollow protective film comprises a first cap layer (7) contacting the source electrode, and a second cap layer (10) placed on the first cap layer.

5. The semiconductor device according to claim 4, wherein the first cap layer is composed of a metal layer, and the second cap layer is composed of a silicon dioxide film.

6. A semiconductor device comprising:
a semiconductor substrate (4A);
a field effect transistor (4) comprising a gate electrode(1), a drain electrode (2), and a source electrode (3) which are formed on the semiconductor substrate; and
a hollow protective film (5) provided on the semiconductor substrate so that an inner surface bonds to an upper surface of the drain electrode of the field effect transistor.

7. The semiconductor device according to claim 6, wherein the hollow protective film comprises a first cap layer (7) contacting the drain electrode, and a second cap layer (10) placed on the first cap layer.

8. The semiconductor device as claimed in any one of the claims 2, 4, 7, wherein
the hollow protective film further comprises a third cap layer placed on the second cap layer.

9. The semiconductor device as claimed in any one of the claims 2, 4, 7, wherein
the first cap layer and the second cap layer are composed of a silicon dioxide film.

10. The semiconductor device according to claim 8, wherein the third cap layer is composed of a silicon nitride film.

11. A fabrication method for a semiconductor device comprising:
forming a gate electrode, a drain electrode, and a source electrode on a semiconductor substrate, and forming a field effect transistor; and
forming a hollow protective film on the semiconductor substrate so that an inner surface bonds to an upper surface of one or both of the drain electrode and the source electrode of the field effect transistor.

12. The fabrication method for the semiconductor device according to claim 11, wherein
the formation of the hollow protective film comprises:
forming a sacrifice layer on the gate electrode and the semiconductor substrate except for the drain electrode and the source electrode;
forming a first cap layer contacting an upper surface of one or both of the drain electrode and the source electrode;
forming an opening on the edge of the first cap layer;
sending in oxygen plasma through the opening, gasifying and removing the sacrifice layer by an oxygen plasma asher, and forming a hollow part; and
forming a second cap layer on the first cap layer, and sealing the opening.

13. The fabrication method for the semiconductor device according to claim 12, wherein
the formation of the hollow protective film further comprises forming a third cap layer on the second cap layer.

14. The fabrication method for the semiconductor device according to claim 13, wherein
the first cap layer is composed of one of an insulating film and a metal layer, and the second cap layer is composed of an insulating film.
